# FASCICULE DE BREVET EUROPEEN

(11) **EP 0 891 872 B1**
(45) Date de publication et mention de la délivrance du brevet: **03.09.2003**
(21) Numéro de dépôt: 98401762.4
(22) Date de dépôt: 10.07.1998
(51) Int. Cl.: B41M 1/34, C03C 17/00, C03C 17/22, C03C 17/36, C03C 17/04, G03F 7/28

(54) **Procédé d'obtention d'un motif sur un substrat transparent**
Verfahren zur Herstellung eines Motivs auf einem transparenten Substrat
Process for obtaining a pattern on a transparent substrat

(30) Priorité: 18.07.1997 FR 9709187
(43) Date de publication de la demande: 20.01.1999
(73) Titulaire: SAINT-GOBAIN GLASS FRANCE, 92400 Courbevoie (FR)
(72) Inventeur: Demars, Yves, 60600 Clermont (FR); Elluin, Jean-Christophe, 60750 Choisy Au Bac (FR); Longchampt, Gilles, 60150 Le-Plessis-Brion (FR)
(74) Mandataire: Muller, René

(56) Documents cités:
- EP-A- 0 074 314
- EP-A- 0 300 300
- EP-A- 0 327 436
- EP-A- 0 394 936
- EP-A- 0 805 126
- FR-A- 2 167 375
- FR-A- 2 736 348
- FR-A- 2 750 419
- GB-A- 2 013 915
- US-A- 4 454 167
- US-A- 5 081 394
- US-A- 5 562 951
- CHEMICAL ABSTRACTS, vol. 104, no. 14, 7 avril 1986 Columbus, Ohio, US; abstract no. 119835, HUANG, JIANXING ET AL: XP002061419 & HUAXUE TONGBAO, vol. 10, 1985, pages 11-12, PEKING CN

## Description

La présente invention concerne un procédé d'obtention d'un motif sur un substrat transparent, notamment en verre ou en vitrocéramique, et également un substrat obtenu selon ce procédé.

Pour obtenir un motif décoratif sur un substrat en verre ou en vitrocéramique, il est bien connu de l'état de la technique d'utiliser des émaux.

Les émaux utilisés pour cette application sont généralement obtenus à partir de ce que l'on appelle une composition d'émail comprenant une poudre constituée essentiellement d'au moins une fritte de verre (qui joue le rôle de matrice vitreuse) et de pigments en tant que colorants notamment, la fritte de verre et les pigments étant à base d'oxydes métalliques, et d'un médium permettant l'application de la composition d'émail sur le substrat et son adhésion temporaire avec celui-ci. Le médium choisi selon la destination de l'émail doit assurer une bonne mise en suspension des particules de fritte et de pigments utilisés et doit se consumer lors de la cuisson de l'émail. Ce médium peut comprendre des solvants, des diluants, des huiles, des résines...

Il est connu de déposer ces émaux par différentes techniques d'impression, tout particulièrement par des techniques de sérigraphie à l'aide d'une toile dont le maillage et l'ouverture des mailles sont fonction du motif à obtenir. Ces techniques d'impression sont très avantageuses d'un point de vue économique dans la mesure où elles permettent la fabrication en grande série à une cadence importante. En outre, elles sont très bien adaptées à la reproduction de motifs décoratifs de grandes dimensions sur des substrats de type verrier.

Par exemple, EP-A-0 074 314 prévoit de déposer l'émail en suspension dans un liant organique polymérisable aux UV, de soumettre le dépôt aux UV afin de fixer l'émail, puis ultérieurement de calciner le liant et de vitrifier l'émail.

Cependant, ces techniques ne donnent pas entière satisfaction, notamment en termes de souplesse d'utilisation et d'esthétisme.

En effet, d'une part un changement de motif à reproduire impose nécessairement un changement de toiles de sérigraphie, ce qui est contraignant sur le plan industriel, notamment quand on vise une production « personnalisée » en petite série.

D'autre part, la technique même de la sérigraphie laisse visible dans le motif décoratif une trame révélatrice de l'original. Visuellement, le substrat revêtu du motif tramé a quelque peu l'aspect d'un tissu.

Il est également connu de l'art antérieur, lorsqu'une application décorative sur un support en un matériau quelconque est visée, notamment la formation d'une image visible colorée, d'utiliser des résines photosensibles comme supports de pigments ou de colorants.

Pour une telle application, il est connu de procéder de deux manières différentes pour utiliser ces résines photosensibles :
→ la première consiste à incorporer l'ingrédient désiré (pigment ou colorant) directement à la composition contenant la résine photosensible, puis à exposer celle-ci au travers d'un cliché positif ou négatif par l'intermédiaire d'une lampe à U.V. et enfin à dépouiller à l'aide d'un solvant adéquat de manière à obtenir une image insoluble qui contient ledit ingrédient sur le support.

En outre, cette étape de dépouillement est d'une mise en oeuvre lourde et compliquée d'autant plus qu'il faut trouver une parfaite affinité entre le solvant utilisé et la résine, et maîtriser les conditions opératoires, notamment en terme de durée.
→ la deuxième consiste à exposer tout d'abord la résine photosensible de la même façon que précédemment puis soit à faire absorber le(s) pigment(s) directement par les parties non insolees de ladite résine soit à les faire adhérer sur lesdites parties (voir US-A-4 454 167), et enfin de dépouiller l'ensemble à l'aide d'un solvant approprié.

Outre le fait que ces deux manières de procéder ont en commun de ne pas être adaptées aux motifs décoratifs de grandes dimensions, tout particulièrement parce qu'il est difficile d'avoir une bonne répartition des pigments sur toute la surface du support, elles présentent également l'inconvénient majeur de ne pas être des solutions durables dans le temps car les pigments ou colorants tendent à se désolidariser du support.

L'invention a alors pour but de remédier aux inconvénients précités, et notamment de proposer un nouveau procédé d'obtention d'un motif sur un substrat transparent, notamment en verre ou en vitrocéramique, adaptable à la fois aux petites et aux grandes séries et qui permette d'avoir un motif particulièrement esthétique, de très haute définition et durable dans le temps sans que cela se fasse au détriment du coût de fabrication.

Pour ce faire, l'invention a pour objet un procédé d'obtention d'un motif sur un substrat transparent, notamment en verre ou en vitrocéramique.

Selon l'invention, on réalise les étapes suivantes, notamment de manière successive
a) on dépose sur au moins une zone d'une des faces du substrat une première couche d'une résine photosensible comportant au moins un agent sensibilisateur et au moins un composé photosensible essentiellement constitué d'un polymère de degré moyen de réticulation d° tel qu'il est apte absorber des particules solides,
b) on insole certaines plages de ladite première couche, notamment pour augmenter de manière contrôlée le degré moyen de réticulation d° dudit polymère afin d'en moduler sa capacité d'absorption,
c) on dépose sur ladite première couche au moins une deuxième couche d'une composition à base de particules minérales,
d) on soumet ledit substrat à au moins un cycle de traitement, notamment pour permettre la fixation desdites particules minérales.

Dans le cadre de l'invention, on comprend par motif tout ce qui est susceptible de modifier l'apparence et/ou la structure du substrat transparent nu, soit en lui donnant un effet particulier, soit en lui donnant l'aspect ornemental sous la forme d'une représentation, éventuellement dans un but d'identification, soit en lui donnant d'autres fonctions. Une partie de ces autres fonctions sera détaillée par la suite.

Dans le contexte de l'invention, on entend par « particules minérales », tout élément minéral réflecteur à indice de réfraction très éloigné par rapport à celui du substrat transparent nu.

De même, il faut comprendre que parmi « les particules minérales » qui apportent la modification de l'apparence et/ou la structure du substrat transparent nu, au moins une partie sert de liant dont la température de fusion est inférieure à celle à laquelle on soumet le substrat.

Pour ce qui est de l'étape de « fixation des particules minérales » relative à l'étape d) selon l'invention, elle peut être provisoire ou définitive en fonction du type de traitement que l'on fait subir au substrat.

Ainsi la fixation provisoire est par exemple obtenue par un traitement aux ultraviolets (UV) qui durcit toute la couche de résine photosensible déposée.

Les avantages apportés par ce type de traitement sont multiples.

En effet, la manipulation du substrat devient aisée et il est alors possible de le transporter avant d'obtenir une fixation définitive des particules minérales conformes à l'invention.

En outre, ce traitement permet d'avoir une parfaite planéité de la couche de résine photosensible, ce qui peut s'avérer nécessaire, notamment au cas où une autre couche du même type est superposée, comme ce sera décrit par la suite.

De même, la fixation définitive des particules minérales peut être obtenue par un cycle de traitement thermique. C'est alors la partie précitée qui sert de liant qui fond lors de ce même cycle de traitement thermique.

Bien évidemment, comme il le sera décrit ci-après une variante de l'invention peut consister en ce que toutes les particules minérales fondent lors du cycle de traitement thermique de l'étape d).

Tel est le cas par exemple d'une fritte de verre dite à bas point de fusion, c'est-à-dire à point de fusion inférieur à la température de déformation du substrat, c'est-à-dire dans la plupart des cas inférieur à 750-800°C, généralement inférieur à 650°C.

Dans ce cas précis, on obtient un motif décoratif à effet sablé (la surface vitrée étant plus ou moins diffusante).

On précise tout de suite que dans le cadre de l'invention, par fritte de verre, on comprend une composition vitrifiable substantiellement transparente, sous forme de poudre à base d'oxydes métalliques sans pigment.

Selon l'invention, l'expression « un polymère de degré moyen de réticulation d° tel qu'il est apte à absorber des particules solides » signifie que l'on choisit un polymère dont le réseau est initialement lâche pour insérer, de manière provisoire, les particules minérales. En d'autres termes, on s'assure d'une bonne compatibilité entre les interstices du réseau du polymère et la granulométrie des particules choisie.

Lorsqu'on insole sélectivement, on rend plus ou moins dense le réseau dans les plages concernées qui deviennent alors plus ou moins étanches en quelque sorte aux particules minérales.

Le principal avantage de déposer ainsi une composition à base de particules minérales par une technique de photosensibilisation par rapport aux techniques de dépôt par impression du type sérigraphie réside dans le fait que l'on peut faire varier la quantité de particules minérales, telles que définies précédemment, de manière homogène sur toute la surface vitrée concernée. On obtient ainsi un motif décoratif particulier, effet qui ne peut en aucun cas être obtenu par les techniques d'impression par lesquelles tous les points du motif ont nécessairement la même intensité. En outre, plus aucune trace de tramage n'apparaît dans le motif décoratif.

Une conséquence avantageuse du procédé selon l'invention est qu'il est d'une mise en oeuvre simple et peu onéreuse, les conditions opératoires ne nécessitant pas de précaution particulière, si ce n'est une bonne maîtrise de l'étape d'insolation b) de manière à obtenir la variation de la capacité d'absorption du polymère désirée et, par là, la possibilité d'avoir des dégradés dans la gamme des gris par modification de la quantité de particules minérales absorbée.

Subsidiairement, le procédé selon l'invention permet la « personnalisation » à souhait du motif décoratif sans que cela ne nécessite la préparation longue et minutieuse d'un (d') outillage(s) spécifique(s), avantage non négligeable sur le plan industriel.

De préférence, l'agent sensibilisateur choisi est un dérivé du benzothiazole ou du naphtothiazole ou éventuellement dans le but d'étendre la sensibilité spectrale, un sel d'anilinovinyl-hétérocycloammonium. De préférence encore, ledit agent sensibilisateur est le 1-N(méthylbenzothiazolylidène) dithioacétate de méthyle.

Lorsqu'on l'utilise conjointement au polymère tel que défini ci-dessus, son intervalle de sensibilité s'étend jusqu'à une longueur d'onde égale à environ 0,5 micron c'est-à-dire au-delà du domaine des ultra-violets (dont la limite supérieure est égale à 0,38 µm). On s'affranchit ainsi du choix d'une source de rayonnement très spécifique pour réaliser l'étape b).

Avantageusement, le polymère qui s'est révélé être le plus approprié pour absorber les particules minérales finement broyées est le polycynamylidène malonate d'éthylène glycol et de butanédiol.

Pour réaliser l'étape b) du procédé selon l'invention, trois variantes sont envisageables :
- selon la première variante, l'insolation est faite à l'aide d'une source de rayonnement, notamment ultraviolet, éclairant toute la surface d'un cliché reproduisant le motif décoratif et superposé à la première couche,
- selon la deuxième variante, l'insolation est faite par projection d'une image,
- selon la troisième variante préférée, l'insolation est faite à l'aide d'une source de rayonnement ponctuelle, notamment ultra-violet, de préférence un laser, dont le faisceau balaie certaines plages de la première couche.

Cette troisième variante préférée permet d'avoir des dégradés très prononcés à des endroits du motif très localisés puisque l'insolation se fait point par point. De plus, il est possible de « guider » le laser au moyen d'une unité logique programmée en fonction du motif décoratif à obtenir, ce qui confère une souplesse d'utilisation lorsque le procédé selon l'invention est mis en oeuvre sur ligne industrielle.

Selon une caractéristique très avantageuse, le choix de la granulométrie des particules minérales, qui est avant tout adaptée à la capacité d'absorption du polymère comme mentionné plus haut, est fait en fonction de l'épaisseur de la première couche de telle sorte que leur diamètre est inférieur ou égal à cette dernière.

Pour cela, on réalise un broyage très fin des particules minérales, broyage d'autant plus fin que l'on cherche à avoir un contraste important entre les différentes parties du motif décoratif et/ou une résolution du motif importante. Ainsi, un diamètre des particules inférieur d₉₀ inférieur ou égal à 10 µm, de préférence compris entre 4 et 8 µm est particulièrement préféré car il correspond bien aux différentes épaisseurs de couches de résine photosensible une fois déposées et séchées.

De même, le diamètre des particules d₁₀ est de préférence choisi entre 0,2 µm et 1 µm et, de préférence encore, le diamètre d₅₀ est compris entre 1 µm et 4 µm. On rappelle que ces termes « d₉₀ », « d₅₀ » et « d₁₀ » signifient que respectivement 90%, 50 % et 10 % des particules minérales en question ont un diamètre inférieur à la valeur indiquée. La valeur d₉₀ donne une idée claire de la taille des particules. Combinée avec les valeurs de d₁₀ et/ou d₅₀, elle précise de manière complète la distribution des tailles de particules dans une gamme donnée de valeurs de diamètre.

Pour ce qui est de l'étape d), on soumet le substrat, de préférence, à un cycle de traitement thermique des particules minérales, à des températures supérieures ou égales aux températures de fusion de ces particules notamment comprises entre 300 et 750°C, de préférence encore aux alentours de 620°C.

De toute manière, la résine photosensible doit s'éliminer à des températures inférieures à celles nécessaires pour réaliser la fusion des particules minérales.

Avantageusement, le cycle de traitement thermique précité fait partie d'un cycle de traitement thermique de trempe, de recuit ou de bombage.

On profite ainsi de la température de fixation des particules minérales pour conférer une résistance mécanique particulière au substrat en verre.

Préalablement à ce cycle de traitement thermique de fixation des particules, on peut soumettre le substrat à un premier cycle de traitement thermique de manière à brûler la résine photosensible.

Ce premier cycle de traitement thermique est particulièrement avantageux car il permet d'éviter absolument tout phénomène de « cloquage » de la résine de se produire. On s'assure ainsi que l'intégrité, et en particulier les contours des motifs, est conservée après les traitements thermiques.

De manière avantageuse, on effectue ce traitement thermique secondaire à une température de l'ordre de 350°C, pendant un temps d'environ 6 minutes par µm d'épaisseur de la première couche. En fonction du type de modification d'apparence et/ou de structure que l'on veut apporter au substrat transparent nu, la composition à base de particules minérales peut comprendre une poudre métallique et/ou une poudre céramique et/ou une poudre à base d'oxydes métalliques et/ou de particules fonctionnelles du type cristaux liquides ou particules de phosphore. Comme poudre métallique, il peut s'agir d'une poudre d'argent, d'or ou d'oxyde de ruthénium.

Comme cristaux liquides, l'homme de l'art les choisira en fonction de la couleur du motif que l'on cherche à obtenir qui dépendra par exemple de la nature de ces cristaux et de l'incidence sous laquelle l'observateur les voit. Dans le cas d'une poudre « mixte » comprenant une poudre métallique avec une poudre d'oxydes métalliques, cette dernière joue avantageusement le rôle de liant.

Lorsqu'on recherche plutôt un aspect ornemental, la composition à base de particules minérales comprend de préférence une composition d'émail comportant au moins une fritte de verre.

Pour ce qui est du choix de la composition d'émail, il est à la portée de l'homme de l'art qui adaptera celle-ci en fonction du substrat, notamment de sa nature et de son épaisseur.

De manière connue, la fritte de verre contient des oxydes formateurs pour former les constituants essentiels de la matière vitreuse, des oxydes modificateurs aptes à modifier cette matrice vitreuse et capables d'influer sur le point de fusion et des oxydes intermédiaires qui, selon leur environnement et leurs proportions jouent le rôle d'oxyde formateur et/ou d'oxydes modificateurs.

L'homme de l'art, en fonction d'une part de la quantité d'oxydes modificateurs, d'autre part des rapports entre oxydes intermédiaires et oxydes formateurs choisira la composition d'émail ayant les caractéristiques de température adaptées à l'invention.

Selon une caractéristique avantageuse de l'invention, la fritte de verre comprend, en proportions pondérales, les éléments suivants :

| | |
|---|---|
| PbO | 40 - 75 % |
| ZnO | 0 - 7 % |
| Al₂O₃ | 0 - 5 % |
| SiO₂ | 1 - 35 % |
| ZrO₂ | 1 - 5 % |
| B₂O₃ | 0 - 10 % |
| K₂O | 0 - 0,2 % |
| BaO | 0 - 0,2 % |
| SrO | 0 - 0,2 % |

Selon une variante préférée de l'invention et lorsqu'on désire obtenir un motif décoratif formé d'une image visible, on ajoute à la composition d'émail, préalablement à son dépôt, des pigments, de préférence d'une seule teinte.

Dans cette configuration préférée on fait jouer à l'émail d'une manière judicieuse, le rôle de liant. En effet, l'émail crée une matrice vitreuse idéale pour solidariser les pigments au support en verre de façon durable dans le temps.

Selon l'invention, il est préférable d'ajouter des pigments dans des proportions telles que le rapport en poids entre la fritte de verre et les pigments soit compris entre 50/50 et 90/10 de préférence entre 70/30 et 60/40 pour 100 parties de mélange fritte et pigments.

Pour avoir la meilleure homogénéité possible entre les pigments et la fritte de verre, on choisit avantageusement une granulométrie des pigments sensiblement égale à celle des particules de la fritte de verre. De manière préférée, le diamètre des pigments est inférieur à 10 µm, notamment compris entre 1 et 5 µm.

Lorsque l'on désire obtenir un aspect métallisé du motif décoratif, il est préférable d'avoir majoritairement des pigments de mica.

Lorsqu'on souhaite obtenir une image en polychrome de très haute définition, on réalise selon l'invention, n fois successivement les étapes a) b) c) sur la même zone en déposant alternativement une résine hydrophile et une résine hydrophobe, les n compositions d'émail étant remarquables en ce que chacune d'entre elles comporte majoritairement des pigments de noir ou de blanc ou conférant une seule couleur.

Selon cette variante, lorsqu'on souhaite obtenir une image en quadrichromie (n = 4), les quatre compositions d'émail comportent majoritairement ensemble des pigments de noir et conférant les trois couleurs fondamentales, chacune d'entre elles comportant majoritairement des pigments de noir ou conférant une seule des trois couleurs fondamentales.

En ce qui concerne la formulation des pigments, on choisit de préférence l'oxyde de titane TiO₂ comme pigment de blanc.

De même, pour des pigments conférant la couleur fondamentale bleue (cyan), on choisit avantageusement des pigments de Co₃O₄. Enfin, pour des pigments conférant la couleur fondamentale rouge (magenta) et jaune, on choisit de préférence des pigments d'oxyde de cadmium CdO mélangés à des pigments de sulfo-sélénure de cadmium dont on module les proportions relatives pour obtenir l'une (rouge) ou l'autre (jaune) des couleurs fondamentales.

Selon cette même variante, la première résine photosensible déposée est avantageusement hydrophile.

L'invention a aussi pour objet un substrat transparent, par exemple en verre ou en vitrocéramique, notamment obtenu par le procédé selon l'invention, qui comporte sur une de ses faces au moins une zone émaillée reproduisant un motif décoratif dont la caractéristique essentielle réside dans le fait qu'il présente un effet de dégradé par modification de la quantité de particules minérales. L'effet de dégradé est particulièrement avantageux dans la gamme de gris.

Ce substrat est remarquable en ce qu'il présente dans la zone émaillée, un coefficient de transmission lumineuse strictement positif, notamment compris entre 0,05 et 90 % pour une couche émaillée d'épaisseur inférieure à 10 µm, de préférence inférieure à 5 µm. Un tel substrat est particulièrement avantageux car, dans la mesure où le motif décoratif peut être vu de ses deux côtés, son champ d'application est beaucoup plus large que les substrats émaillés existants. En outre, le motif décoratif est visible à très grande distance.

De préférence, la résolution du motif décoratif est supérieure à 15 D.p.i. (« Dots per inch », c'est-à-dire point par pouce »), avantageusement supérieure à 150 D.p.i.

Le motif décoratif peut être une image visible monochrome ou polychrome, notamment quadrichrome, et lorsque tel est le cas, la résolution de l'image est conforme à ce qui précède. Une telle finesse autorise la vision de l'image à plusieurs distances, ce qui se traduit par le fait que deux observateurs situés à une distance différente du substrat distingueront des détails de l'image différents.

L'invention est applicable à la fabrication de tout vitrage décoratif à haute résolution tel qu'une enseigne lumineuse vitrée, une porte de four vitrée avec un bandeau de cuisinière, une vitrine, cloison interne, un vitrail. On peut également associer en le feuilletant le vitrage selon l'invention avec un autre vitrage de manière à lui conférer des propriétés particulières. Cet autre vitrage peut par exemple être un substrat transparent revêtu de couches minces lui apportant une fonctionnalité bien spécifique telle qu'une fonction anti-reflet, anti-buée, anti-salissure.

L'invention est également applicable à la fabrication de « faces avant » d'écrans émissifs du type écrans plats tels que des écrans plasma.

En effet, un écran plasma est constitué de deux substrats de verre superposés l'un sur l'autre, constituant les faces avant et arrière de l'écran.

Si la technique de sérigraphie est tout à fait convenable en termes de précision pour déposer les éléments de la « face arrière » et plus particulièrement les luminophores et les électrodes à base de pâte d'Argent, elle n'est pas nécessairement suffisante pour déposer les éléments de la face avant du fait même que ces derniers doivent être quasi parfaitement en regard d'éléments semblables de la face arrière.

La haute résolution fournie par le procédé de l'invention précité est, quant à elle, parfaitement adaptée.

Par exemple, il est possible de déposer, au regard de chaque luminophore de la face arrière, et à partir d'une poudre céramique éventuellement mélangée à une fritte de verre à bas point de fusion à l'aide de la technique selon l'invention, un filtre coloré sélectif de la longueur d'onde désirée.

Il est également possible de procéder au dépôt des électrodes à base de pâte d'argent auxquelles on demande d'être parfaitement perpendiculaires à celles de la face arrière.

Enfin, en vue d'améliorer le rendement lumineux de l'écran plasma, on peut tout aussi bien déposer des luminophores qu'il était jusqu'ici difficile de déposer en couches très fines sur la face avant.

D'autres détails et caractéristiques avantageuses ressortent ci-après de l'exemple suivant, non limitatif, conforme à l'invention.

On prépare en lumière inactinique une solution contenant 120 g/litre d'une résine photosensible.

Pour cela, on broie tout d'abord 150 g de polycynamylidène malonate d'éthylène glycol et de butanédiol de densité d = 1,237, que l'on solubilise dans 1 litre d'un premier solvant qui contient respectivement 53 % de toluène, 21 % de butylacétate et 26 % de 2-méthoxyéthylacétate.

On broie également 4,5 g d'un sensibilisateur qui est le 1-N(méthylbenzothiazolylidène) dithiocétate de méthyle que l'on solubilise à saturation dans un deuxième solvant qui contient 30 % de butylacétate et 70 % de 2-méthoxyéthylacétate puis on filtre le tout et enfin on l'incorpore au premier solvant.

On applique une couche de cette solution qui présente une viscosité de l'ordre de 28 Pals sur un substrat en verre à l'aide d'un pinceau souple par exemple.

L'épaisseur moyenne de cette couche de résine photosensible est inférieure à 5 µm après séchage pendant 30 mn à 60°C. On insole certaines parties du produit photosensible ainsi obtenu à l'aide d'un laser UV d'une puissance d'environ 1 kW dont le faisceau est dévié point par point par un miroir de manière à reproduire l'image visible que l'on souhaite obtenir.

On applique alors de manière homogène une deuxième couche d'une composition d'émail sur toute la première couche de résine photosensible insolée par endroit.

Pour réaliser cette composition on effectue tout d'abord un rebroyage par voie liquide d'une fritte de verre à base de calcin d'un verre silico-sodo-calcique clair de manière à obtenir des particules très fines.

La granulométrie des particules de la fritte de verre a été mesurée : les diamètres d₁₀, d₅₀, d₉₀ ont respectivement une valeur de 0,2 µm, 1,25 µm et 10 µm.

Puis, on mélange à ces particules finement broyées des pigments d'oxyde de titane TiO₂ dont les diamètres d₁₀, d₅₀, d₉₀ ont respectivement une valeur de 0,4 µm, 2 µm, 7 µm dans une proportion telle que le rapport en poids entre pigments et fritte de verre est égal à 48/52 pour 100 parties du mélange fritte et pigments.

La composition de l'émail est en proportions pondérales la suivante : 42 % de PbO, 4,9 % de ZnO, 1,9 % de SiO₂, 1,4 % de ZrO₂, 0,9 % d'Al₂O₃, 0,14 % de SrO et 48 % de TiO₂.

Enfin, on mélange l'ensemble fritte de verre plus pigments ainsi constitué à un médium qui est de l'alcool.

Une fois cette deuxième couche de composition d'émail appliquée, on effectue un séchage dans une étuve à 60°C pendant 30 secondes en évacuant les vapeurs d'alcool.

On effectue alors un lavage à l'eau tiède à une température de l'ordre de 50°C tout en brossant à l'aide d'une brosse au poil doux la deuxième couche.

Parallèlement à cette étape de lavage, on récupère par décantation dans un bac l'excès d'émail non absorbé par la première couche de résine photosensible.

Enfin on soumet le substrat ainsi revêtu à un cycle de traitement thermique. Celui-ci se décompose en un brûlage de la résine à 350°C pendant 1 heure puis en une cuisson de l'émail et une trempe du substrat en verre aux alentours de 620°C.

Le substrat ainsi obtenu comporte une zone émaillée qui reproduit une image monochrome visible de très haute définition, dont la résolution est égale à 150 D.p.i. Cette excellente résolution est directement liée à la capacité de concentration du faisceau laser, et notamment de l'ordre de 10 µm.

En outre, on a étalonné, dans cette zone émaillée, de manière arbitraire les niveaux de gris de 0 à 21 pour chacun desquels on a mesuré le coefficient de transmission lumineuse. Les valeurs sont regroupées dans le tableau ci-dessous :

**TABLEAU**

| **niveau de gris** | **coefficient de transmission lumineuse** |
|---|---|
| 1 | 87,1 |
| 2 | 56,2 |
| 3 | 38,0 |
| 4 | 26,3 |
| 5 | 17,8 |
| 6 | 12,6 |
| 7 | 8,9 |
| 8 | 5,9 |
| 9 | 4,3 |
| 10 | 2,9 |
| 11 | 2,1 |
| 12 | 1,5 |
| 13 | 1,1 |
| 14 | 0,7 |
| 15 | 0,5 |
| 16 | 0,40 |
| 17 | 0,28 |
| 18 | 0,22 |
| 19 | 0,15 |
| 20 | 0,10 |
| 21 | 0,07 |

De ce tableau, il ressort clairement que l'opacité de l'image peut être réglée dans une large gamme et donc qu'il est possible d'obtenir des contrastes très prononcés.

Il va de soi que de nombreuses modifications de détail peuvent être apportées au procédé décrit ci-dessus sans pour autant sortir du cadre de l'invention.

Par exemple, il est possible de moduler la dévitrification de la fritte de verre de manière à obtenir une image en couleur sans avoir à utiliser des pigments.

De même, le médium optionnel utilisé pour déposer la composition d'émail sur la couche de résine photosensible peut être couché préalablement au dépôt des particules de la fritte de verre.

Enfin, pour ce qui est du dépôt sélectif des particules, on peut, outre la sélectivité apportée par la source d'insolation, apporter une deuxième sélectivité en répartissant de manière hétérogène sur toute la surface des particules.

## Revendications

1. Procédé d'obtention d'un motif sur un substrat transparent, notamment en verre ou en vitrocéramique, **caractérisé en ce qu**'on réalise les étapes suivantes, notamment de manière successive :
a) on dépose sur au moins une zone d'une des faces du substrat une première couche d'une résine photosensible comportant au moins un agent sensibilisateur et au moins un composé photosensible essentiellement constitué d'un polymère ayant un degré moyen de réticulation d° tel qu'il est apte à absorber des particules solides et une capacité d'absorption qui varie en fonction de l'insolation,
b) on insole certaines plages de ladite première couche notamment pour augmenter le degré moyen de réticulation d° dudit polymère afin de moduler sa capacité à absorber des particules solides,
c) on dépose sur ladite première couche au moins une deuxième couche d'une composition à base de particules minérales,
d) on soumet ledit substrat à au moins un cycle de traitement thermique, notamment pour permettre la fixation desdites particules minérales.

2. Procédé selon la revendication 1, **caractérisé en ce que** le traitement du substrat selon l'étape d) est un traitement thermique ou aux ultraviolets.

3. Procédé selon la revendication 1 ou 2, **caractérisé en ce que** ledit agent sensibilisateur est le 1-N (méthylbenzothiazolylidène) dithioacétate de méthyle.

4. Procédé selon l'une quelconque des revendications précédentes, **caractérisé en ce que** ledit polymère est le polycynamylidène malonate d'éthylène glycol et de butanédiol.

5. Procédé selon l'une quelconque des revendications précédentes, **caractérisé en ce qu**'on réalise l'étape b) soit à l'aide d'une source de rayonnement, notamment ultraviolet, éclairant toute la surface d'un cliché reproduisant le motif décoratif et superposé à ladite première couche, soit à l'aide d'une source de rayonnement ponctuelle, notamment ultraviolet, de préférence un laser, dont le faisceau balaie lesdites plages de la première couche, soit par projection d'une image.

6. Procédé selon l'une quelconque des revendications précédentes, **caractérisé en ce qu'**on choisit une granulométrie des particules minérales telles que leur diamètre est inférieur ou égal à l'épaisseur de ladite première couche.

7. Procédé selon la revendication 6, **caractérisé en ce que** le diamètre desdites particules minérales, d₉₀ est inférieur ou égal à 10 µm, de préférence compris entre 4 et 8 µm.

8. Procédé selon l'une quelconque des revendications précédentes, **caractérisé en ce que** selon l'étape d) on soumet le substrat à un cycle de traitement thermique de fixation des particules minérales, à des températures supérieures ou égales aux températures de fusion d'au moins une partie des particules minérales, notamment comprises entre 300°C et 750°C, de préférence égales à 620°C.

9. Procédé selon la revendication 8, **caractérisé en ce que** le cycle de traitement thermique de fixation des particules minérales fait partie d'un cycle de trempe, recuit ou bombage dudit substrat.

10. Procédé selon la revendication 8 ou 9, **caractérisé en ce que,** préalablement au cycle de traitement thermique de fixation des particules minérales, on soumet le substrat à un cycle de traitement thermique de manière à brûler ladite résine photosensible, de préférence à une température de l'ordre de 350°C pendant un temps d'environ 6 à 24 minutes par µm d'épaisseur de ladite première couche.

11. Procédé selon l'une quelconque des revendications précédentes, **caractérisé en ce que** ladite composition à base de particules minérales comprend une poudre métallique et/ou une poudre céramique et/ou une poudre à base d'oxydes métalliques et/ou des particules fonctionnelles du type cristaux liquides ou particules de phosphore.

12. Procédé selon la revendication 10, **caractérisé en ce que** ladite composition à base de particules minérales comprend une composition d'émail comportant au moins une fritte de verre.

13. Procédé selon la revendication 12, **caractérisé en ce que** ladite composition d'émail comprend également des pigments, de préférence d'une seule teinte.

14. Procédé selon la revendication 13, **caractérisé en ce qu**'on choisit une granulométrie des pigments sensiblement égale à celle des particules de la fritte de verre.

15. Procédé selon la revendication 13 ou 14, **caractérisé en ce que** le diamètre d₉₀ des pigments est inférieur à 10 µm, de préférence compris entre 1 et 5 µm.

16. Procédé selon l'une quelconque des revendications 13 à 15, **caractérisé en ce qu**'on ajoute des pigments dans des proportions telles que le rapport en poids entre la fritte de verre et les pigments est compris entre 50/50 et 90/10, de préférence entre 70/30 et 60/40, pour 100 parties de mélange fritte et pigments.

17. Procédé selon l'une des revendications 13 à 16, **caractérisé en ce que** ladite composition d'émail comporte majoritairement des pigments de mica.

18. Procédé selon l'une des revendications 13 à 17, **caractérisé en ce qu**'on réalise successivement n fois les étapes a) b) c) sur la même zone, en déposant alternativement une résine hydrophile et une résine hydrophobe **et en ce que** chacune des n compositions d'émail comporte majoritairement des pigments de noir, de blanc ou d'une couleur.

19. Procédé selon la revendication 18, **caractérisé en ce que** lorsque n est égal à 4, les quatre compositions d'émail comportent majoritairement ensemble des pigments de noir ou blanc et conférant les trois couleurs fondamentales ou complémentaires et **en ce que** chacune d'entre elles comporte majoritairement des pigments de noir ou blanc ou conférant une seule des trois couleurs fondamentales.

20. Procédé selon la revendication 18 ou 19, **caractérisé en ce que** la première résine photosensible déposée est hydrophile.

21. Substrat transparent, notamment obtenu par le procédé selon l'une des revendications 1 à 20, comportant sur une de ses faces au moins un motif décoratif comprenant des particules minérales, **caractérisé en ce que** le motif présente un effet de dégradé par modification de la quantité desdites particules absorbée.

22. Substrat selon la revendication 21, **caractérisé en ce que** le motif est constitué d'émail.

23. Substrat selon l'une des revendications 21 ou 22, **caractérisé en ce qu'**il est en verre ou en vitrocéramique.

24. Substrat selon l'une des revendications 21 à 23, **caractérisé en ce que** la résolution dudit motif décoratif est supérieure à 15 D.p.i, avantageusement supérieure à 150 D.p.i.

25. Substrat selon l'une des revendications 21 ou 24, **caractérisé en ce que** la couleur dudit motif décoratif est monochrome ou polychrome, notamment quadrichrome.

26. Utilisation du substrat selon l'une des revendications 21 à 25 en tant que verre décoratif à haute résolution.

27. Application du procédé selon l'une quelconque des revendications 1 à 20 à la fabrication de vitrages décoratifs tels qu'une enseigne lumineuse vitrée, une porte de four vitrée avec un bandeau de cuisinière, une vitrine, un vitrail.

28. Application procédé selon l'une quelconque des revendications 1 à 12 à la fabrication de "faces avant" d'écrans émissifs du type écrans plats tels que des écrans plasma.

## Patentansprüche

1. Verfahren zur Herstellung eines Musters auf einem speziell aus Glas oder Glaskeramik bestehenden transparenten Substrat, **dadurch gekennzeichnet, dass** folgende Stufen insbesondere nacheinander durchgeführt werden:
a) Aufbringen einer ersten Schicht aus einem lichtempfindlichen Harz, das mindestens einen Sensibilisator und mindestens eine lichtempfindliche Verbindung umfasst, die im Wesentlichen aus einem Polymer mit einem solchen mittleren Vernetzungsgrad d°, dass es in der Lage ist, feste Teilchen aufzunehmen, und mit einem in Abhängigkeit von der Bestrahlung variierenden Aufnahmevermögen besteht, in wenigstens einem Bereich einer Seite des Substrats,
b) Bestrahlen bestimmter Bereiche der ersten Schicht, insbesondere zur Erhöhung des mittleren Vernetzungsgrades d° des Polymers, um dessen Aufnahmevermögen für feste Teilchen zu modifizieren,
c) Aufbringen mindestens einer zweiten Schicht aus einer Zusammensetzung auf der Basis anorganischer Teilchen auf dieser ersten Schicht und
d) Unterwerfen des Substrats mindestens einer Wärmebehandlung, insbesondere, um die Fixierung der anorganischen Teilchen zu ermöglichen.

2. Verfahren nach Anspruch 1, **dadurch gekennzeichnet, dass** die Behandlung des Substrats gemäß Stufe d) eine Behandlung mit Wärme oder Ultraviolettstrahlung ist.

3. Verfahren nach Anspruch 1 oder 2, **dadurch gekennzeichnet, dass** der Sensibilisator Methyl-1-N(methylbenzothiazolyliden)dithioacetat ist.

4. Verfahren nach einem der vorhergehenden Ansprüche, **dadurch gekennzeichnet, dass** das Polymer Polyethylenglykolbutandiolcinnamylidenmalonat ist.

5. Verfahren nach einem der vorhergehenden Ansprüche, **dadurch gekennzeichnet, dass** Stufe b) mittels einer insbesondere ultravioletten Strahlungsquelle, welche die gesamte Oberfläche eines Klischees bestrahlt, welches das dekorative Muster reproduziert und sich auf der ersten Schicht befindet, mittels einer insbesondere ultravioletten Punktstrahlungsquelle, vorzugsweise eines Lasers, dessen Strahl die Bereiche der ersten Schicht abtastet, oder durch Bildprojektion durchgeführt wird.

6. Verfahren nach einem der vorhergehenden Ansprüche, **dadurch gekennzeichnet, dass** eine derartige Korngröße für die anorganischen Teilchen gewählt wird, dass deren Durchmesser kleiner als oder gleich der Dicke der ersten Schicht ist.

7. Verfahren nach Anspruch 6, **dadurch gekennzeichnet, dass** der Durchmesser d₉₀ der anorganischen Teilchen weniger als oder gleich 10 µm und vorzugsweise 4 bis 8 µm beträgt.

8. Verfahren nach einem der vorhergehenden Ansprüche, **dadurch gekennzeichnet, dass** in Stufe d) das Substrat einer Wärmebehandlung zur Fixierung der anorganischen Teilchen bei einer Temperatur von über oder gleich der Schmelztemperatur mindestens eines Teils der anorganischen Teilchen, insbesondere von 300 bis 750 °C, und vorzugsweise gleich 620 °C unterworfen wird.

9. Verfahren nach Anspruch 8, **dadurch gekennzeichnet, dass** die Wärmebehandlung zur Fixierung der anorganischen Teilchen Bestandteil des Vorspannens, Abkühlens im Kühlofen oder Biegens des Substrats ist.

10. Verfahren nach Anspruch 8 oder 9, **dadurch gekennzeichnet, dass** das Substrat vor der Wärmebehandlung zur Fixierung der anorganischen Teilchen einer derartigen Wärmebehandlung, dass das lichtempfindliche Harz verbrennt, vorzugsweise bei einer Temperatur von etwa 350 °C, etwa 6 bis 24 Minuten pro um Dicke der ersten Schicht unterworfen wird.

11. Verfahren nach einem der vorhergehenden Ansprüche, **dadurch gekennzeichnet, dass** die Zusammensetzung auf der Basis anorganischer Teilchen ein Metallpulver und/oder ein Keramikpulver und/oder ein Pulver auf der Basis von Metalloxiden und/oder funktionelle Teilchen vom Typ Flüssigkristalle oder Leuchtstoffteilchen umfasst.

12. Verfahren nach Anspruch 10, **dadurch gekennzeichnet, dass** die Zusammensetzung auf der Basis anorganischer Teilchen eine Emailzusammensetzung umfasst, die mindestens eine Glasfritte enthält.

13. Verfahren nach Anspruch 12, **dadurch gekennzeichnet, dass** die Emailzusammensetzung auch Pigmente mit vorzugsweise nur einem Farbton enthält.

14. Verfahren nach Anspruch 13, **dadurch gekennzeichnet, dass** die Korngröße der Pigmente etwa gleich der der Glasfrittenteilchen gewählt wird.

15. Verfahren nach Anspruch 13 oder 14, **dadurch gekennzeichnet, dass** der Durchmesser d₉₀ der Pigmente weniger als 10 µm und vorzugsweise 1 bis 5 µm beträgt.

16. Verfahren nach einem der Ansprüche 13 bis 15, **dadurch gekennzeichnet, dass** die Pigmente mit derartigen Anteilen zugesetzt werden, dass das Gewichtsverhältnis von Glasfritte zu Pigmenten 50/50 bis 90/10 und vorzugsweise 70/30 bis 60/40 auf 100 Teile Fritte-Pigment-Gemisch beträgt.

17. Verfahren nach einem der Ansprüche 13 bis 16, **dadurch gekennzeichnet, dass** die Email Zusammensetzung überwiegend Glimmerpigmente enthält.

18. Verfahren nach einem der Ansprüche 13 bis 17, **dadurch gekennzeichnet, dass** die Stufen a), b) und c) n Mal nacheinander in demselben Bereich durchgeführt werden, indem abwechselnd ein hydrophiles und ein hydrophobes Harz aufgebracht wird, **und dass** die jeweilige der n Emailzusammensetzungen überwiegend schwarze, weiße oder farbige Pigmente enthält.

19. Verfahren nach Anspruch 18, **dadurch gekennzeichnet, dass,** wenn n 4 ist, die vier Emailzusammensetzungen überwiegend gemeinsam Pigmente enthalten, die schwarz oder weiß sind oder die drei Grund- bzw. Komplementärfarben verleihen, **und dass** jede von ihnen überwiegend Pigmente enthält, die schwarz oder weiß sind oder nur eine der drei Grundfarben verleihen.

20. Verfahren nach Anspruch 18 oder 19, **dadurch gekennzeichnet, dass** das zuerst aufgebrachte lichtempfindliche Harz hydrophil ist.

21. Transparentes Substrat, das insbesondere durch das Verfahren nach einem der Ansprüche 1 bis 20 erhalten ist und welches auf einer Seite mindestens ein anorganische Teilchen enthaltendes dekoratives Muster umfasst, **dadurch gekennzeichnet, dass** das Muster durch Modifizierung der aufgenommenen Teilchenmenge eine Abstufung aufweist.

22. Substrat nach Anspruch 21, **dadurch gekennzeichnet, dass** das Muster aus Email besteht.

23. Substrat nach Anspruch 21 oder 22, **dadurch gekennzeichnet, dass** es aus Glas oder Glaskeramik besteht.

24. Substrat nach einem der Ansprüche 21 bis 23, **dadurch gekennzeichnet, dass** die Auflösung des dekorativen Musters höher als 15 dpi und vorteilhafterweise höher als 150 dpi ist.

25. Substrat nach Anspruch 21 oder 24, **dadurch gekennzeichnet, dass** die Farbe des dekorativen Musters einfarbig oder mehrfarbig und insbesondere vierfarbig ist.

26. Verwendung des Substrats nach einem der Ansprüche 21 bis 25 als dekoratives Glas mit hoher Auflösung.

27. Anwendung des Verfahrens nach einem der Ansprüche 1 bis 20 auf die Herstellung einer dekorativen Verglasung wie einer gläsernen Leuchtreklame, einer gläsernen Ofentür für einen Küchenherd, eines Schaukastens und eines eingefassten Fensters.

28. Anwendung des Verfahrens nach einem der Ansprüche 1 bis 12 auf die Herstellung der Vorderseite von selbstleuchtenden Bildschirmen vom Typ Flachbildschirmen wie Plasmabildschirmen.

## Claims

1. Method of obtaining a pattern on a transparent substrate, in particular one made of glass or glass-ceramic,
**characterised in that** the following steps are carried out, in particular successively:
a) there is deposited on at least one area of one of the faces of the substrate a first layer of a photosensitive resin comprising at least one sensitising agent and at least one photosensitive compound essentially consisting of a polymer having a mean degree of cross-linking d° such that it is capable of absorbing solid particles and an absorption capacity which varies as a function of the insolation;
b) certain regions of said first layer are insolated in particular in order to increase the mean degree of cross-linking d° of said polymer in order to modulate its capacity to absorb solid particles;
c) there is deposited on said first layer at least one second layer of a composition based on mineral particles;
d) said substrate is subjected to at least one heat treatment cycle, in particular to allow the fixing of said mineral particles.

2. Method according to Claim 1, **characterised in that** the treatment of the substrate according to step d) is a heat or ultraviolet treatment.

3. Method according to Claim 1 or 2, **characterised in that** said sensitising agent is methyl 1-N (methylbenzothiazolylidene) dithioacetate.

4. Method according to any one of the preceding claims, **characterised in that** said polymer is ethylene glycol and butanediol polycynamylidene malonate.

5. Method according to any one of the preceding claims, **characterised in that** step b) is carried out either using a source of radiation, in particular ultraviolet, illuminating the entire surface of a plate reproducing the decorative pattern and superimposed on said first layer, or using a point source of radiation, in particular ultraviolet, preferably a laser, the beam of which sweeps said regions of the first layer, or by projection of an image.

6. Method according to any one of the preceding claims, **characterised in that** a granulometry of the mineral particles is chosen such that their diameter is less than or equal to the thickness of said first layer.

7. Method according to Claim 6, **characterised in that** the diameter of said mineral particles, d₉₀, is less than or equal to 10 µm, preferably between 4 µm and 8 µm.

8. Method according to any one of the preceding claims, **characterised in that**, according to step d), the substrate is subjected to a heat treatment cycle for fixing the mineral particles, at temperatures greater than or equal to the melting temperatures of at least some of the mineral particles, in particular between 300°C and 750°C, preferably equal to 620°C.

9. Method according to Claim 8, **characterised in that** the heat treatment cycle for fixing the mineral particles forms part of a cycle of tempering, annealing or bending of said substrate.

10. Method according to Claim 8 or 9, **characterised in that**, prior to the heat treatment cycle for fixing the mineral particles, the substrate is subjected to a heat treatment cycle so as to burn said photosensitive resin, preferably at a temperature of the order of 350°C for a time of around 6 to 24 minutes per µm of thickness of said first layer.

11. Method according to any one of the preceding claims, **characterised in that** said composition based on mineral particles comprises a metallic powder and/or a ceramic powder and/or a metal oxide-based powder and/or functional particles of the liquid crystal type or phosphorus particles.

12. Method according to Claim 10, **characterised in that** said composition based on mineral particles comprises an enamel composition comprising at least one glass frit.

13. Method according to Claim 12, **characterised in that** said enamel composition also comprises pigments, preferably of a single shade.

14. Method according to Claim 13, **characterised in that** a granulometry of the pigments substantially equal to that of the particles of the glass frit is chosen.

15. Method according to Claim 13 or 14, **characterised in that** the diameter d₉₀ of the pigments is less than 10 µm, preferably between 1 µm and 5 µm.

16. Method according to any one of Claims 13 to 15, **characterised in that** pigments are added in proportions such that the ratio in terms of weight between the glass frit and the pigments is between 50/50 and 90/10, preferably between 70/30 and 60/40, for 100 parts of frit and pigments mixture.

17. Method according to one of Claims 13 to 16, **characterised in that** said enamel composition comprises a majority of mica pigments.

18. Method according to one of Claims 13 to 17, **characterised in that** the steps a) b) c) are carried out successively n times on the same area, depositing alternately a hydrophilic resin and a hydrophobic resin, and **in that** each of the n enamel compositions comprises a majority of pigments of black, white or a colour.

19. Method according to Claim 18, **characterised in that**, when n is equal to 4, the four enamel compositions together comprise a majority of pigments of black or white and giving the three fundamental or complementary colours, and **in that** each of them comprises a majority of pigments of black or white or giving a single one of the three fundamental colours.

20. Method according to Claim 18 or 19, **characterised in that** the first photosensitive resin deposited is hydrophilic.

21. Transparent substrate, in particular obtained by the method according to one of Claims 1 to 20, having on one of its faces at least one decorative pattern comprising mineral particles, **characterised in that** the pattern has a shaded effect by modification of the quantity of said particles absorbed.

22. Substrate according to Claim 21, **characterised in that** the pattern consists of enamel.

23. Substrate according to either of Claims 21 or 22, **characterised in that** it is made of glass or glass-ceramic.

24. Substrate according to one of Claims 21 to 23, **characterised in that** the resolution of said decorative pattern is greater than 15 d.p.i., advantageously greater than 150 d.p.i.

25. Substrate according to either of Claims 21 or 24, **characterised in that** the colour of said decorative pattern is monochrome or polychrome, in particular four-colour.

26. Use of the substrate according to one of Claims 21 to 25 as a high resolution decorative glass.

27. Application of the method according to any one of Claims 1 to 20 to the manufacture of decorative glazing panes such as a glazed luminous sign, a glazed oven door with a cooker banner, a shop window, a stained glass window.

28. Application of the method according to any one of Claims 1 to 12 to the manufacture of "front faces" of emissive screens of the flat screen type such as plasma screens.
